# EUROPEAN PATENT APPLICATION

(11) **EP 4 133 957 A1**
(43) Date of publication of application: **15.02.2023**
(21) Application number: 21784936.3
(22) Date of filing: 01.04.2021
(51) Int. Cl.: A24F 40/50, A24F 47/00

(54) **ELECTRONIC ATOMIZATION DEVICE, USE STATE DETECTION METHOD, DEVICE, AND READABLE STORAGE MEDIUM**

(30) Priority: 07.04.2020 CN 202010264910
(71) Applicant: Shenzhen Merit Technology Co., Ltd., Shenzhen, Guangdong 518000 (CN)
(72) Inventor: CHEN, Junliang, Shenzhen, Guangdong 518000 (CN)
(74) Representative: Corradini, Corrado
(86) International application number: PCT/CN2021/084926
(87) International publication number: WO 2021/204057

(57) **Abstract**

An electronic atomization device, a use state detection method, a use state detection device, and a computer readable storage medium. The electronic atomization device comprises: a heat generation unit (110) used to heat an aerosol generation product; a resonance unit (120) used to produce an electromagnetic field for the heat generation unit (110) to generate heat; a detection unit (130) used to detect an energy attenuation feature of the electromagnetic field and output a detection signal; a control unit (140) used to output an excitation signal that excites the resonance unit (120) to produce the electromagnetic field, and further used to determine a state of the aerosol generation product according to the detection signal. The invention uses the control unit (140) to excite the resonance unit (120) to produce the electromagnetic field, such that the heat generation unit (110) performs induction heating, and enables, by means of the detection unit (130), detection of the energy attenuation feature of the electromagnetic field, such that the control unit (140) determines the state of the aerosol generation product according to the detection signal. In this way, whether the aerosol generation product is loaded is determined simply according to the energy attenuation feature of the electromagnetic field.

## Description

### CROSS-REFERENCES TO RELATED APPLICATIONS

This application claims priority to Chinese patent application No. 202010264910.6, entitled "ELECTRONIC ATOMIZATION DEVICE, USE STATE DETECTION METHOD, DEVICE, AND READABLE STORAGE MEDIUM" and filed on April 7, 2020, the contents of which are hereby incorporated by reference in their entirety.

### TECHNICAL FIELD

The present application relates to the field of electronic atomization device technologies, and in particular, to an electronic atomization device, a use state detection method and device, and a readable storage medium.

### BACKGROUND

With the development of a heat-not-burn electronic atomization device technology, a technology for detecting the state of an aerosol-generating article has emerged, that is, detecting whether the aerosol-generating article is loaded during using the device. If the aerosol-generating article is not loaded, the electronic atomization device is controlled not to heat, so as to prevent no-load operation when the aerosol-generating article is not loaded.

For example, the aerosol-generating article is a cigarette, and a heat-not-burn electronic atomization device is also called a low-temperature not-burn baking electronic atomization device. The cigarette is inserted into the electronic atomization device and heated by a heating device, and the cigarette is baked to produce areosol for a user to smoke. In order to prevent damages to a cigarette insertion opening when not in use, a slide cover is generally provided to cover the cigarette insertion opening when not in use. Therefore, at present, the state of the aerosol-generating article is detected by converting detected position movement of the slide cover of the cigarette insertion opening into a switching signal and sending the switching signal to a main control board, that is, determining whether a cigarette is inserted indirectly according to whether the slide cover is open.

However, the current use state detection method requires adding a circuit configured to detect a position of the slide cover of the cigarette insertion opening. The circuit is complicated in design and costly, and only depends on the position of the slide cover for detection. In a situation where the slide cover is open but no cigarette is inserted, misjudgment may occur and reliability is low.

### SUMMARY

Based on the above, there is a need to provide, with respect to the above technical problems, an electronic atomization device, a use state detection method and device, and a readable storage medium that can improve reliability of detection.

An electronic atomization device is provided, including:
a heat generation unit configured to heat an aerosol-generating article;
a resonance unit configured to produce an electromagnetic field for inducting the heat generation unit to generate heat;
a detection unit configured to detect the energy attenuation characteristic of the electromagnetic field and output a detection signal; and
a control unit configured to output an excitation signal that excites the resonance unit to produce the electromagnetic field, and further configured to determine the state of the aerosol-generating article according to the detection signal.

In one embodiment, the resonance unit includes a resonance circuit and a controlled switch.

The resonance circuit has a first terminal electrically connected to a power source and a second terminal electrically connected to the input terminal of the controlled switch. The resonance circuit is configured to produce the electromagnetic field for causing the heat generation unit to generate heat.

The controlled switch has an output terminal connected to ground and a controlled terminal electrically connected to the excitation signal output terminal of the control unit. The input terminal of the controlled switch is electrically connected to the input terminal of the detection unit.

In one embodiment, the detection unit includes a comparator.

The comparator has a positive input terminal electrically connected to the input terminal of the controlled switch, a negative input terminal electrically connected to a reference power source, and an output terminal electrically connected to the detection signal input terminal of the control unit.

A use state detection method applied to an electronic atomization device is also provided, the method including:
outputting an excitation signal for exciting a resonance unit to produce an electromagnetic field, the electromagnetic field being used to induct a heat generation unit to generate heat, the heat generation unit being configured to heat an aerosol-generating article;
acquiring a detection signal fed back by a detection unit, the detection unit being configured to detect the energy attenuation characteristic of the electromagnetic field and output the detection signal; and
determining the state of the aerosol-generating article according to the detection signal.

In one embodiment, the excitation signal is a pulse excitation signal, and the determining the state of the aerosol-generating article according to the detection signal includes:
calculating the pulse number of the detection signal;
determining whether the pulse number is greater than a preset pulse number; and
determining that the state of the aerosol-generating article is unloaded if the pulse number is greater than the preset pulse number.

In one embodiment, the excitation signal is a pulse excitation signal, and the determining the state of the aerosol-generating article according to the detection signal includes:
calculating the pulse width of the detection signal;
determining whether the pulse width is greater than a preset pulse width; and
determining that the state of the aerosol-generating article is unloaded if the pulse width is greater than the preset pulse width.

In one embodiment, the pulse width is the pulse width of at least one pulse.

In one embodiment, the excitation signal is a pulse excitation signal, and the determining the state of the aerosol-generating article according to the detection signal includes:
calculating the pulse number and the pulse width of the detection signal; and
determining that the state of the aerosol-generating article is unloaded if the pulse number is greater than a preset pulse number and the pulse width is greater than a preset pulse width.

In one embodiment, the outputting the excitation signal includes: outputting the excitation signal according to a preset cycle.

In one embodiment, the step of outputting an excitation signal includes: outputting the excitation signal when an activation signal is received, the activation signal being used to activate the electronic atomization device.

In one embodiment, the step of outputting an excitation signal includes: outputting the excitation signal when a heating signal is received, the heating signal being used to instruct the electronic atomization device to start heating.

A use state detection device applied to an electronic atomization device is further provided, the use state detection device including:
an excitation signal output module configured to output an excitation signal for exciting a resonance unit to produce an electromagnetic field, the electromagnetic field being used to induct a heat generation unit to generate heat, the heat generation unit being configured to heat an aerosol-generating article;
a detection signal acquisition module configured to acquire the detection signal fed back by a detection unit, the detection unit being configured to detect the energy attenuation characteristic of the electromagnetic field and output the detection signal; and
a state determination module configured to determine the state of the aerosol-generating article according to the detection signal.

A computer readable storage medium storing a computer program is further provided, the computer program, when executed by a processor, causing the processor to implement steps of the method described above.

According to the electronic atomization device, the use state detection method and device, and the readable storage medium, the control unit outputs the excitation signal to drive the resonance unit, the resonance unit produces the electromagnetic field for causing the heat generation unit to generate heat, and the detection unit is configured to detect the energy attenuation characteristic of the electromagnetic field and output the detection signal to the control unit, such that the control unit determines the state of the aerosol-generating article according to the detection signal. An energy consumption rate of the resonance unit varies with the state of the aerosol-generating article. Therefore, whether the aerosol-generating article is loaded can be determined simply according to the energy attenuation characteristic of the electromagnetic field, which requires no complex circuit and can effectively improve reliability of detection results.

### BRIEF DESCRIPTION OF THE DRAWINGS

FIG. 1 is a schematic structural diagram illustrating an electronic atomization device according to an embodiment of the present application.
FIG. 2 is a schematic structural diagram illustrating a resonance unit according to an embodiment of the present application.
FIG. 3 is a schematic diagram illustrating a circuit configuration of the resonance unit and a detection circuit according to an embodiment of the present application.
FIG. 4 is a schematic flow diagram illustrating a use state detection method according to an embodiment of the present application.
FIG. 5 is a schematic flow diagram illustrating a step of determining the state of an aerosol-generating article according to a detection signal according to an embodiment of the present application.
FIG. 6 is a schematic flow diagram illustrating the step of determining the state of the aerosol-generating article according to the detection signal according to another embodiment of the present application.
FIG. 7 is a schematic flow diagram illustrating the step of determining the state of the aerosol-generating article according to the detection signal according to yet another embodiment of the present application.
FIG. 8 is a schematic diagram illustrating waveforms of a pulse excitation signal corresponding to the detection signal in different states of the aerosol-generating article according to an embodiment of the present application.
FIG. 9 is a block diagram illustrating a configuration of a use state detection device according to an embodiment of the present application.
FIG. 10 is a block diagram illustrating a configuration of a state determination module according to an embodiment of the present application.
FIG. 11 is a block diagram illustrating a configuration of a state determination module according to another embodiment of the present application.
FIG. 12 is a diagram illustrating an internal configuration of a computer apparatus according to an embodiment of the present application.

### DETAILED DESCRIPTION OF THE EMBODIMENTS

In order to make the objectives, technical solutions, and advantages of the present application more clearly understood, the present application is described in further detail below through embodiments in conjunction with the accompanying drawings. It is to be understood that specific embodiments described herein are intended only to interpret the present application and not intended to limit the present application.

It is to be noted that, when an element is referred to as being "connected to" another element, it may be directly connected to or integrated with the other element or an intervening element may be present.

Unless defined otherwise, all technical and scientific terms used herein have the same meanings as would generally understood by those skilled in the technical field of the present invention. The terms used herein in the specification of the present invention are for the purpose of describing specific embodiments only, and are not intended to limit the present invention. The term "and/or" used herein includes any and all combinations of one or more related listed items.

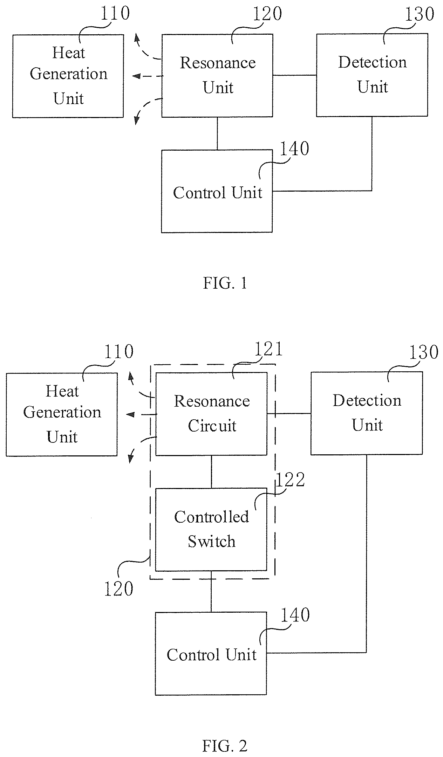

In one embodiment, as shown in FIG. 1, an electronic atomization device is provided, including: a heat generation unit 110 configured to heat an aerosol-generating article;
a resonance unit 120 configured to produce an electromagnetic field for inducting the heat generation unit 110 to generate heat;
a detection unit 130 configured to detect the energy attenuation characteristic of the electromagnetic field and output a detection signal; and
a control unit 140 configured to output an excitation signal that excites the resonance unit 120 to produce the electromagnetic field, and further configured to determine the state of the aerosol-generating article according to the detection signal.

According to the principle of energy conservation, when the control unit 140 outputs the excitation signal, the resonance unit 120 stores energy. When the excitation signal stops, the resonance unit 120 outputs the energy. The resonance unit 120 generates an alternating current under the excitation of the excitation signal, and then produces an alternating magnetic field, so that the heat generation unit 110 in the alternating magnetic field can achieve electromagnetic induction heating. When the excitation signal stops, the energy stored in the resonance unit 120 may gradually decay till disappearance. An energy consumption rate of the resonance unit 120 may be affected by whether the aerosol-generating article is loaded. When the aerosol-generating article is loaded, the resonance unit 120 is required to consume more energy for the heat generation unit 110. Therefore, compared to a situation where part of the energy is used to heat the aerosol-generating article after the aerosol-generating article is loaded, the heat generation unit 110 has less energy when the aerosol-generating article is not loaded into the electronic atomization device, and thus energy of the electromagnetic field decays more slowly. If the aerosol-generating article is loaded into the electronic atomization device, the energy of the electromagnetic field may decay faster. The excitation signal outputted by the control unit 140 excites the resonance unit 120 to produce the electromagnetic field, and the energy of the electromagnetic field oscillates and decays until the energy is consumed completely and disappears. The detection unit 130 can detect the energy attenuation characteristic of the electromagnetic field and feed the energy attenuation characteristic back to the control unit 140. The control unit 140 may determine the state of the aerosol-generating article by analyzing the detection signal according to a preset rule. In one embodiment, the excitation signal is a pulse excitation signal. The pulse excitation signal includes one or several pulses, so as to identify the state of the aerosol-generating article and prevent long-time continuous heating of the heat generation unit 110 due to long-time generation of the electromagnetic field by the resonance unit 120.

According to the electronic atomization device, the control unit 140 outputs the excitation signal to drive the resonance unit 120 to produce the electromagnetic field, such that the heat generation unit 110 is excited by the electromagnetic field to generate heat, and the detection unit 130 is configured to detect the energy attenuation characteristic of the electromagnetic field and output the detection signal to the control unit 140, such that the control unit 140 determines the state of the aerosol-generating article according to the detection signal. An energy consumption rate of the electromagnetic field produced by the resonance unit 120 varies with the state of the aerosol-generating article. Therefore, whether the aerosol-generating article is loaded can be determined simply according to the energy attenuation characteristic of the electromagnetic field, which requires no complex circuit and can effectively improve reliability of detection results.

In one embodiment, the control unit 140 is further configured to output the excitation signal according to a preset cycle.

To make a user use the electronic atomization device more safely, the state of the aerosol-generating article may be detected over a preset cycle. The control unit 140 outputs the excitation signal according to the preset cycle, so as to effectively prevent no-load operation in a case where the aerosol-generating article is not loaded.

In one embodiment, the control unit 140 is further configured to output the excitation signal when receiving an activation signal. The activation signal is used to activate the electronic atomization device.

Generally, the user may use the electronic atomization device to heat the aerosol-generating article for use after controlling the electronic atomization device to be activated. Moreover, some electronic atomization devices may not be provided with heating control separately, but directly perform heating after being activated. Therefore, the control unit 140 may also output the excitation signal to excite the resonance unit 120 when receiving the activation signal, so as to detect the state of the aerosol-generating article in time.

In one embodiment, the control unit 140 is further configured to output the excitation signal when receiving a heating signal. The heating signal is used to instruct the electronic atomization device to start heating.

Some electronic atomization devices are provided with a separate heating control function. When the user wants to use such electronic atomization device, the heating signal may be inputted to the electronic atomization device to control the electronic atomization device to start heating. When the user does not want to use such electronic atomization device, input of the heating signal is stopped, and the electronic atomization device stops heating, which can save electricity and reduce consumption of the aerosol-generating article. Therefore, in order to prevent no-load operation, the control unit 140 may also output the excitation signal when receiving the heating signal.

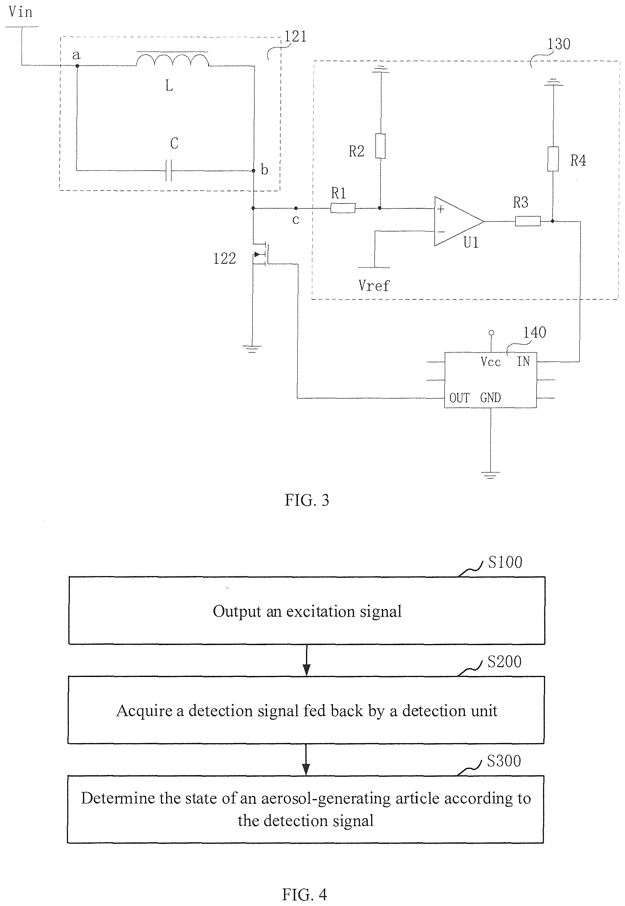

In one embodiment, as shown in FIG. 2 and FIG. 3, the resonance unit 120 includes a resonance circuit 121 and a controlled switch 122.

The resonance circuit 121 has a first terminal electrically connected to a power source and a second terminal b electrically connected to the input terminal of the controlled switch 122. The resonance circuit 121 is configured to produce the electromagnetic field for causing the heat generation unit 110 to generate heat.

The controlled switch 122 has an output terminal connected to ground and a controlled terminal electrically connected to the excitation signal output terminal OUT of the control unit 140. The input terminal of the controlled switch 122 is electrically connected to an input terminal c of the detection unit 130.

In this embodiment, description is based on an example in which the control unit 140 includes a control chip. The excitation signal output terminal OUT of the control unit 140 outputs the excitation signal. The excitation signal drives the controlled switch 122 to be switched on. After the output of the excitation signal stops, the controlled switch 122 is switched off. When the controlled switch 122 is switched on, the resonance circuit 121 is powered on to form a loop, and the resonance circuit 121 stores energy. When the controlled switch 122 is switched off, the resonance circuit 121 releases the energy, causing a coil of the resonance circuit 121 to produce an alternating electromagnetic field. The electromagnetic field may oscillate, and if no power is continuously supplied to the resonance circuit 121, the electromagnetic field may gradually decay till disappearance. Therefore, the excitation signal is a short-time output signal. The output of the excitation signal may stop when the resonance circuit 121 is excited to produce the electromagnetic field to oscillate, which realizes rapid and short-time detection on the state of the aerosol-generating article. Meanwhile, the heat generation unit 110 may not generate heat for a long time due to long-time generation of the electromagnetic field. In this way, long-time no-load operation can be prevented when the aerosol-generating article is not loaded, and a waste of the aerosol-generating article can be prevented when the aerosol-generating article is loaded. In one embodiment, the control unit 140 further includes functional circuits that implement other functions (not shown in the figure), which may be configured by those skilled in the art according to function requirements of the electronic atomization device.

In one embodiment, as shown in FIG. 3, the resonance circuit 121 is an LC parallel resonance circuit, and the controlled switch 122 is an N-channel metal oxide semiconductor (NMOS) transistor. The NMOS transistor has a gate acting as the controlled terminal of the controlled switch 122, a source acting as the output terminal of the controlled switch 122, and a drain acting as the input terminal of the controlled switch 122. When the control unit 140 outputs a high level to the gate of the NMOS transistor, the controlled switch 122 is switched on.

In one embodiment, as shown in FIG. 3, the detection unit 130 includes a comparator U1.

The comparator U1 has a positive input terminal electrically connected to the input terminal of the controlled switch 122, a negative input terminal electrically connected to a reference power source Vref, and an output terminal electrically connected to a detection signal input terminal IN of the control unit 140.

The comparator U1 compares a voltage at the second terminal b of the resonance circuit 121 with a voltage of the reference power source and outputs a plurality of pulse signals as detection signals for the control unit 140 to analyze.

In one embodiment, as shown in FIG. 3, the detection unit 130 further includes a first resistor R1, a second resistor R2, a third resistor R3, and a fourth resistor R4.

The first resistor R1 has a first terminal electrically connected to the input terminal of the controlled switch 122 and a second terminal electrically connected to the positive input terminal of the comparator U1. The second resistor R2 has a first terminal electrically connected to the positive input terminal of the comparator U1 and a second terminal connected to GND. The third resistor R3 has a first terminal electrically connected to the output terminal of the comparator U1 and a second terminal electrically connected to the detection signal input terminal IN of the control unit 140. The fourth resistor R4 has a first terminal electrically connected to the second terminal of the third resistor R3 and a second terminal connected to GND.

In one embodiment, the aerosol-generating article contains a ferromagnetic material.

When the aerosol-generating article is an aerosol-generating article containing the ferromagnetic material, the heat generation unit 110 may be regarded as having an increased area, so that in a state that the aerosol-generating article is loaded, the resonance circuit 121 may consume energy completely in a shorter time, resulting in fewer pulses and a narrower pulse width, and the pulses vary greatly between a state in the presence of the aerosol-generating article and a state in the absence of the aerosol-generating article, thereby achieving higher detection accuracy.

In one embodiment, as shown in FIG. 4, a use state detection method is provided. For example, the method is applied to the control unit 140 in FIG. 1 and includes the following steps.

In step S100, an excitation signal is outputted. The excitation signal is used to excite a resonance unit 120 to produce an electromagnetic field, the electromagnetic field is used to induct a heat generation unit 110 to generate heat, and the heat generation unit 110 is configured to heat an aerosol-generating article.

In step S200, a detection signal fed back by a detection unit 130 is acquired. The detection unit 130 is configured to detect the energy attenuation characteristic of the electromagnetic field and output the detection signal.

In step S300, the state of the aerosol-generating article is determined according to the detection signal.

According to the law of energy conservation, driven by the excitation signal, the resonance unit 120 produces the electromagnetic field to excite the heat generation unit 110 to generate heat. After the excitation signal disappears, energy of the electromagnetic field may gradually decay till disappearance. Moreover, depending on whether the heat generation unit 110 is required to heat the aerosol-generating article, energy consumed by the heat generation unit 110 varies, and the energy of the electromagnetic field may decay at a different speed. Therefore, compared to a situation where part of the energy is used to heat the aerosol-generating article after the aerosol-generating article is loaded, the heat generation unit 110 consumes less energy when the aerosol-generating article is not loaded into the electronic atomization device, and thus the energy of the electromagnetic field decays more slowly. If the aerosol-generating article is loaded into the electronic atomization device, the energy of the electromagnetic field may decay faster. The excitation signal outputted by the control unit 140 excites the resonance unit 120 to produce the electromagnetic field, and the energy of the electromagnetic field constantly oscillates and decays until the energy is consumed completely and disappears. In one embodiment, the excitation signal is a pulse excitation signal. The pulse excitation signal includes one or several pulses, so as to identify the state of the aerosol-generating article and prevent long-time heating of the heat generation unit 110 due to long-time generation of the electromagnetic field by the resonance unit 120. The detection unit 130 can detect the energy attenuation characteristic of the electromagnetic field and feed the energy attenuation characteristic back to the control unit 140. The control unit 140 may determine the state of the aerosol-generating article by analyzing the detection signal according to a preset rule.

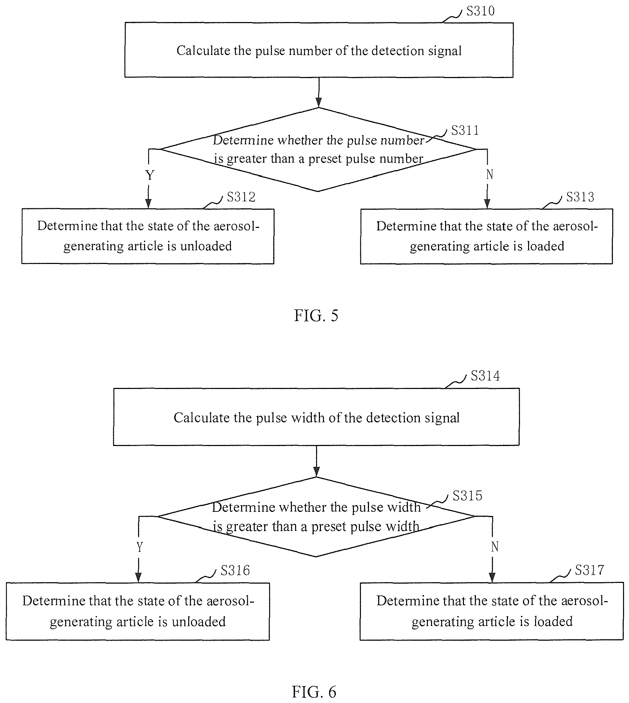

In one embodiment, the excitation signal is a pulse excitation signal. As shown in FIG. 5, the step of determining the state of the aerosol-generating article according to the detection signal includes the following steps.

In step S310, the pulse number of the detection signal is calculated.

The detection signal corresponds to the whole process of the electromagnetic field from generation to disappearance. The speed of energy attenuation of the electromagnetic field may be determined according to the pulse number of the detection signal.

In step S311, it is determined whether the pulse number is greater than a preset pulse number.

The preset pulse number is a critical point that differentiates the speeds of energy attenuation of the electromagnetic field corresponding to an unloaded state and a loaded state respectively. Whether the state of the aerosol-generating article is the loaded state or the unloaded state may be determined by determining whether the pulse number of the detection signal is greater than the preset pulse number.

In step S312, it is determined that the state of the aerosol-generating article is unloaded if the pulse number is greater than the preset pulse number.

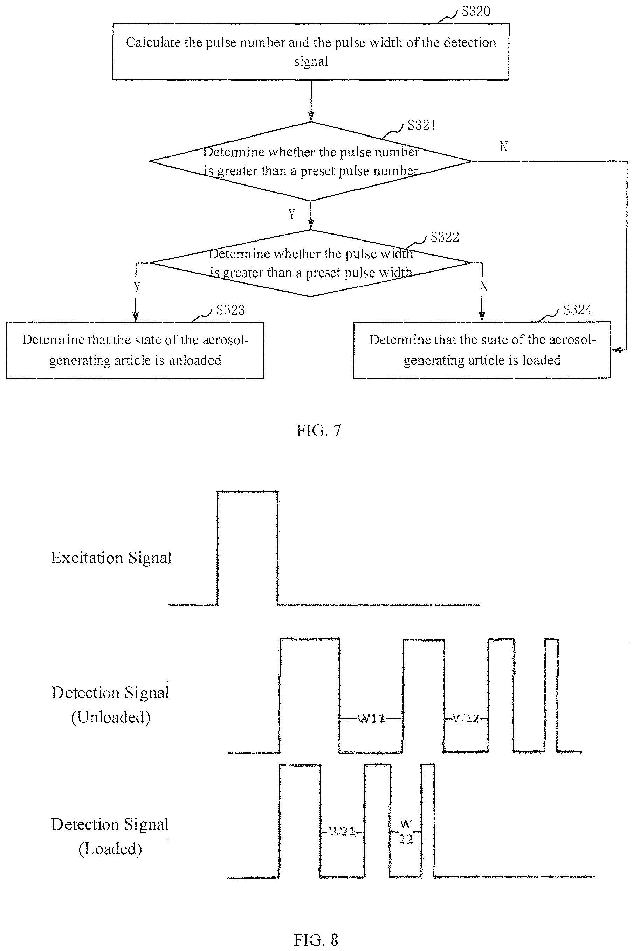

According to the law of energy conservation, as shown in FIG. 8, in one embodiment, under the excitation of a same pulse excitation signal, the pulse number of the detection signal is 4 when the aerosol-generating article is not loaded, but is 3 when the aerosol-generating article is loaded. That is, if the aerosol-generating article is not loaded, spontaneous magnetization intensity of the heat generation unit decreases faster, magnetic induction energy is transferred more slowly, and the resonance unit 120 takes longer to consume the energy completely, so that the energy attenuation of the electromagnetic field is slower. Therefore, it can be determined that the state of the aerosol-generating article is the unloaded state if the pulse number of the detection signal is greater than the preset pulse number.

In step S313, it is determined that the state of the aerosol-generating article is loaded if the pulse number is less than or equal to the preset pulse number.

According to the law of energy conservation, as shown in FIG. 8, if the aerosol-generating article is loaded, a temperature of a heating element rises slowly, the spontaneous magnetization intensity of the heat generation unit decreases more slowly, the magnetic induction energy is transferred faster, and the resonance unit 120 can consume the energy completely in a relatively short time, so that the energy attenuation of the electromagnetic field is accelerated. Therefore, it may be determined that the state of the aerosol-generating article is the loaded state if the pulse number of the detection signal is less than or equal to the preset pulse number.

In one embodiment, as shown in FIG. 7, the step of determining the state of the aerosol-generating article according to the detection signal includes the following steps.

In step S314, the pulse width of the detection signal is calculated.

The detection signal corresponds to the whole process of the electromagnetic field from generation to disappearance. The speed of energy attenuation of the electromagnetic field may also be determined according to the pulse width of the detection signal. The pulse width refers to a width between a falling edge of a previous pulse and a rising edge of a subsequent pulse in two adjacent pulses.

In step S315, it is determined whether the pulse width is greater than a preset pulse width.

The preset pulse width is a critical point that differentiates the speeds of energy attenuation of the electromagnetic field corresponding to an unloaded state and a loaded state respectively. The state of the aerosol-generating article may be determined by determining whether the pulse width of the detection signal is greater than the preset pulse width.

In step S316, it is determined that the state of the aerosol-generating article is unloaded if the pulse width is greater than the preset pulse width.

According to the law of energy conservation, as shown in FIG. 8, in one embodiment, under the excitation of a same pulse excitation signal, the pulse width W11 of a first cycle of the detection signal in the unloaded state of the aerosol-generating article is greater than the pulse width W21 of the first cycle in the loaded state. That is, if the aerosol-generating article is not loaded, spontaneous magnetization intensity of the heat generation unit decreases faster, magnetic induction energy is transferred more slowly, and the resonance unit 120 takes longer to consume the energy completely, so that the energy attenuation of the electromagnetic field is slower, and then the pulse width of a single cycle changes. Therefore, it may be determined that the state of the aerosol-generating article is the unloaded state if the pulse width of the detection signal is greater than the preset pulse width.

In step S317, it is determined that the state of the aerosol-generating article is loaded if the pulse width is less than or equal to the preset pulse width.

According to the law of energy conservation, as shown in FIG. 8, if the aerosol-generating article is loaded, the spontaneous magnetization intensity of the heat generation unit decreases more slowly, the magnetic induction energy is transferred faster, and the resonance unit 120 can consume the energy completely in a relatively short time, so that the energy attenuation of the electromagnetic field is accelerated. Therefore, it may be determined that the state of the aerosol-generating article is the loaded state if the pulse width of the detection signal is less than or equal to the preset pulse width.

In one embodiment, the pulse width of the detection signal is the pulse width of at least one pulse. As shown in FIG. 8, the state of the aerosol-generating article may be determined only by comparing pulse widths of W11 and W1 or pulse widths of W12 and W22, or by comparing a plurality of pulse widths. For example, the pulse widths of W11 and W21 and the pulse widths W12 and W22 are compared respectively for comprehensive determination, so as to improve accuracy of the determination.

In one embodiment, as shown in FIG. 7, the step of determining the state of the aerosol-generating article according to the detection signal includes the following steps.

In step S320, the pulse number and the pulse width of the detection signal are calculated.

In step S321, it is determined whether the pulse number is greater than a preset pulse number.

In step S322, it is determined whether the pulse width is greater than a preset pulse width.

In step S323, it is determined that the state of the aerosol-generating article is unloaded if the pulse number is greater than the preset pulse number and the pulse width is greater than the preset pulse width.

In step S324, it is determined that the state of the aerosol-generating article is loaded if the pulse number is less than or equal to the preset pulse number, or the pulse width is less than or equal to the preset pulse width.

In one embodiment, the step of outputting an excitation signal includes:
outputting the excitation signal according to a preset cycle.

To make a user use the electronic atomization device more safely, the state of the aerosol-generating article may be detected within the preset cycle. The control unit 140 outputs the excitation signal according to the preset cycle, so as to effectively prevent no-load operation in a state that the aerosol-generating article is not loaded.

In one embodiment, the step of outputting an excitation signal includes: outputting the excitation signal when an activation signal is received, the activation signal being used to activate the electronic atomization device.

Generally, the user may use the electronic atomization device to heat the aerosol-generating article for use after controlling the electronic atomization device to be activated. Moreover, some electronic atomization devices may not be provided with heating control separately, but directly perform heating after being activated. Therefore, the control unit 140 may also output the excitation signal to excite the resonance unit 120 when receiving the activation signal, so as to detect the state of the aerosol-generating article in time.

In one embodiment, the step of outputting an excitation signal includes: outputting the excitation signal when a heating signal is received, the heating signal being used to instruct the electronic atomization device to start heating.

Some electronic atomization devices are provided with a separate heating control function. When the user wants to use such electronic atomization device, the heating signal may be inputted to the electronic atomization device to control the electronic atomization device to start heating. When the user does not want to use such electronic atomization device, input of the heating signal is stopped, and the electronic atomization device stops heating, which can save electricity and reduce consumption of the aerosol-generating article. Therefore, in order to prevent no-load operation, the control unit 140 may also output the excitation signal when receiving the heating signal.

It is to be understood that, although the steps in the flow diagrams of FIG. 4 to FIG. 7 are shown in sequence as indicated by the arrows, the steps are not necessarily performed in the order indicated by the arrows. Unless otherwise clearly specified herein, the steps are performed without any strict sequence limitation, and may be performed in other orders. In addition, at least some steps in FIG. 4 to FIG. 7 may include a plurality of steps or a plurality of stages, and such steps or stages are not necessarily performed at a same moment, and may be performed at different moments. The steps or stages are not necessarily performed in sequence, and may be performed with other steps or at least part of steps or stages in the other steps in turn or alternately.

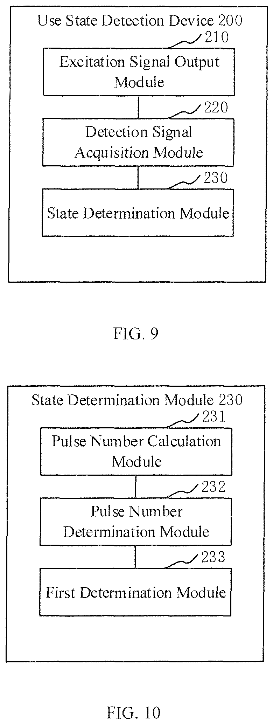

In one embodiment, as shown in FIG. 9, a use state detection device is provided, including: an excitation signal output module 210, a detection signal acquisition module 220, and a state determination module 230.

The excitation signal output module 210 is configured to output an excitation signal. The excitation signal is used to excite a resonance unit 120 to produce an electromagnetic field, the electromagnetic field is used to induct a heat generation unit 110 to generate heat, and the heat generation unit 110 is configured to heat an aerosol-generating article.

The detection signal acquisition module 220 is configured to acquire the detection signal fed back by a detection unit 130. The detection unit 130 is configured to detect the energy attenuation characteristic of the electromagnetic field and output the detection signal.

The state determination module 230 is configured to determine the state of the aerosol-generating article according to the detection signal.

In one embodiment, as shown in FIG. 10, the state determination module 230 includes: the pulse number calculation module 231 configured to calculate the pulse number of the detection signal; the pulse number determination module 232 configured to determine whether the pulse number is greater than a preset pulse number; and a first determination module 233 configured to determine that the state of the aerosol-generating article is unloaded if the pulse number is greater than the preset pulse number.

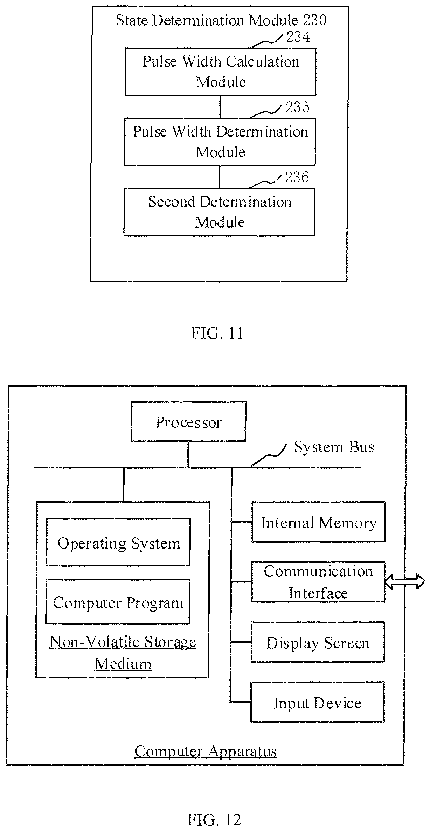

In one embodiment, as shown in FIG. 11, the state determination module 230 includes: the pulse width calculation module 234 configured to calculate the pulse width of the detection signal; the pulse width determination module 235 configured to determine whether the pulse width is greater than a preset pulse width; and a second determination module 236 configured to determine that the state of the aerosol-generating article is unloaded if the pulse width is greater than the preset pulse width.

Specific limitations on the use state detection device may refer to the limitations on the use state detection method hereinabove. Details are not described herein again. The modules in the use state detection device may be implemented entirely or partially by software, hardware, or a combination thereof. The above modules may be built in or independent of a processor of a computer apparatus in a hardware form, or may be stored in a memory of the computer apparatus in a software form, so that the processor invokes and performs operations corresponding to the above modules.

In one embodiment, a computer apparatus is provided. The computer apparatus may be an electronic atomization device, an internal configuration of which is shown in FIG. 12. The computer apparatus includes a processor, a memory, a communication interface, a display screen, and an input device that are connected by using a system bus. The processor of the computer apparatus is configured to provide computing and control capabilities. The memory of the computer apparatus includes a non-volatile storage medium and an internal memory. The non-volatile storage medium stores an operating system and a computer program. The internal memory provides an environment for running of the operating system and the computer program in the non-volatile storage medium. The communication interface of the computer apparatus is configured to communicate with an external terminal in a wired or wireless manner. The wireless manner may be implemented by Wi-Fi, a service provider network, near field communication (NFC), or other technologies. The computer program is executed by the processor to implement a use state detection method. The display screen of the computer apparatus may be a liquid crystal display screen or an electronic ink display screen. The input device of the computer apparatus may be a touch screen covering the display screen, or may be a key, a trackball, or a touchpad disposed on a housing of the computer apparatus.

Those skilled in the art may understand that FIG. 12 only shows a partial configuration related to the solution of the present application, which does not constitute a limitation on the computer apparatus to which the solution of the present application is applied. Specifically, the computer apparatus may include more or fewer components than those shown in the figure, or some components may be combined, or a different component deployment may be used.

In one embodiment, a computer apparatus is provided, including a memory and a processor. The memory stores a computer program. The processor, when executing the computer program, implements the following steps:
outputting an excitation signal for exciting a resonance unit 120 to produce an electromagnetic field, the electromagnetic field being used to induct a heat generation unit 110 to generate heat, the heat generation unit 110 being configured to heat an aerosol-generating article;
acquiring a detection signal fed back by a detection unit 130, the detection unit 130 being configured to detect the energy attenuation characteristic of the electromagnetic field and output a detection signal; and
determining the state of the aerosol-generating article according to the detection signal.

In one embodiment, the processor, when executing the computer program, further implements the following steps:
calculating the pulse number of the detection signal;
determining whether the pulse number is greater than a preset pulse number; and
determining that the state of the aerosol-generating article is unloaded if the pulse number is greater than the preset pulse number.

In one embodiment, the processor, when executing the computer program, further implements the following steps:
calculating the pulse width of the detection signal;
determining whether the pulse width is greater than a preset pulse width; and
determining that the state of the aerosol-generating article is unloaded if the pulse width is greater than the preset pulse width.

In one embodiment, the processor, when executing the computer program, further implements the following steps:
calculating the pulse number and the pulse width of the detection signal; and
determining that the state of the aerosol-generating article is unloaded if the pulse number is greater than the preset pulse number and the pulse width is greater than the preset pulse width.

In one embodiment, the processor, when executing the computer program, further implements the following step:
outputting the excitation signal according to a preset cycle.

In one embodiment, the processor, when executing the computer program, further implements the following step:
outputting the excitation signal when an activation signal is received, the activation signal being used to activate the electronic atomization device.

In one embodiment, the processor, when executing the computer program, further implements the following step:
outputting the excitation signal when a heating signal is received, the heating signal being used to instruct the electronic atomization device to start heating.

In one embodiment, a computer readable storage medium storing a computer program is provided. The computer program, when executed by a processor, causes the processor to implement the following steps:
outputting an excitation signal for exciting a resonance unit 120 to produce an electromagnetic field, the electromagnetic field being used to induct a heat generation unit 110 to generate heat, the heat generation unit 110 being configured to heat an aerosol-generating article;
acquiring a detection signal fed back by a detection unit 130, the detection unit 130 being configured to detect the energy attenuation characteristic of the electromagnetic field and output a detection signal; and
determining the state of the aerosol-generating article according to the detection signal.

In one embodiment, the processor, when executing the computer program, further implements the following steps:
calculating the pulse number of the detection signal;
determining whether the pulse number is greater than a preset pulse number; and
determining that the state of the aerosol-generating article is unloaded if the pulse number is greater than the preset pulse number.

In one embodiment, the processor, when executing the computer program, further implements the following steps:
calculating the pulse width of the detection signal;
determining whether the pulse width is greater than a preset pulse width; and
determining that the state of the aerosol-generating article is unloaded if the pulse width is greater than the preset pulse width.

In one embodiment, the processor, when executing the computer program, further implements the following steps:
calculating the pulse number and the pulse width of the detection signal; and
determining that the state of the aerosol-generating article is unloaded if the pulse number is greater than the preset pulse number and the pulse width is greater than the preset pulse width.

In one embodiment, the processor, when executing the computer program, further implements the following steps:
outputting the excitation signal according to a preset cycle.

In one embodiment, the processor, when executing the computer program, further implements the following steps:
outputting the excitation signal when an activation signal is received, the activation signal being used to activate the electronic atomization device.

In one embodiment, the processor, when executing the computer program, further implements the following steps:
outputting the excitation signal when a heating signal is received, the heating signal being used to instruct the electronic atomization device to start heating.

Those of ordinary skill in the art may understand that some or all procedures in the methods in the foregoing embodiments may be implemented by a computer program instructing related hardware, the computer program may be stored in a non-volatile computer-readable storage medium, and when the computer program is executed, the procedures in the foregoing method embodiments may be implemented. Any reference to the memory, storage, database, or other media used in the embodiments provided in the present application may include at least one of a non-volatile memory and a volatile memory. The non-volatile memory may include a read-only memory (ROM), a magnetic tape, a floppy disk, a flash memory, an optical memory, or the like. The volatile memory may include a random access memory (RAM) or an external cache memory. By way of illustration instead of limitation, the RAM is available in a variety of forms, such as a static random access memory (SRAM), a dynamic random access memory (DRAM), or the like.

The technical features in the above embodiments may be randomly combined. For concise description, not all possible combinations of the technical features in the above embodiments are described. However, all the combinations of the technical features are to be considered as falling within the scope described in this specification provided that they do not conflict with each other. The above embodiments only describe several implementations of the present application, and their description is specific and detailed, but cannot therefore be understood as a limitation on the patent scope of the invention. It should be noted that those of ordinary skill in the art may further make variations and improvements without departing from the conception of the present application, and these all fall within the protection scope of the present application. Therefore, the patent protection scope of the present application should be subject to the appended claims.

## Claims

1. An electronic atomization device, comprising:
a heat generation unit configured to heat an aerosol-generating article;
a resonance unit configured to produce an electromagnetic field for inducting the heat generation unit to generate heat;
a detection unit configured to detect the energy attenuation characteristic of the electromagnetic field and output a detection signal; and
a control unit configured to output an excitation signal that excites the resonance unit to produce the electromagnetic field, and further configured to determine the state of the aerosol-generating article according to the detection signal.

2. The electronic atomization device according to claim 1, wherein:
the resonance unit comprises a resonance circuit and a controlled switch;
the resonance circuit has a first terminal electrically connected to a power source and a second terminal electrically connected to the input terminal of the controlled switch;
the resonance circuit is configured to produce the electromagnetic field for causing the heat generation unit to generate heat; and
the controlled switch has an output terminal connected to ground and a controlled terminal electrically connected to the excitation signal output terminal of the control unit, and the input terminal of the controlled switch is electrically connected to the input terminal of the detection unit.

3. The electronic atomization device according to claim 2, wherein the detection unit comprises a comparator, and
the comparator has a positive input terminal electrically connected to the input terminal of the controlled switch, a negative input terminal electrically connected to a reference power source, and an output terminal electrically connected to the detection signal input terminal of the control unit.

4. A use state detection method applied to an electronic atomization device, the method comprising:
outputting an excitation signal for exciting a resonance unit to produce an electromagnetic field, the electromagnetic field being used to induct a heat generation unit to generate heat, the heat generation unit being configured to heat an aerosol-generating article;
acquiring a detection signal fed back by a detection unit, the detection unit being configured to detect the energy attenuation characteristic of the electromagnetic field and output the detection signal; and
determining the state of the aerosol-generating article according to the detection signal.

5. The use state detection method according to claim 4, wherein the excitation signal is a pulse excitation signal, and the determining the state of the aerosol-generating article according to the detection signal comprises:
calculating the pulse number of the detection signal;
determining whether the pulse number is greater than a preset pulse number; and
determining that the state of the aerosol-generating article is unloaded if the pulse number is greater than the preset pulse number.

6. The use state detection method according to claim 4, wherein the excitation signal is a pulse excitation signal, and the determining the state of the aerosol-generating article according to the detection signal comprises:
calculating the pulse width of the detection signal;
determining whether the pulse width is greater than a preset pulse width; and
determining that the state of the aerosol-generating article is unloaded if the pulse width is greater than the preset pulse width.

7. The use state detection method according to claim 6, wherein the pulse width of the detection signal is the pulse width of at least one pulse.

8. The use state detection method according to claim 4, wherein the excitation signal is a pulse excitation signal, and the determining the state of the aerosol-generating article according to the detection signal comprises:
calculating the pulse number and the pulse width of the detection signal; and
determining that the state of the aerosol-generating article is unloaded if the pulse number is greater than a preset pulse number and the pulse width is greater than a preset pulse width.

9. The use state detection method according to any one of claims 4 to 8, wherein the outputting the excitation signal comprises:
outputting the excitation signal according to a preset cycle.

10. The use state detection method according to any one of claims 4 to 8, wherein the outputting the excitation signal comprises:
outputting the excitation signal when an activation signal is received, the activation signal being used to activate the electronic atomization device.

11. The use state detection method according to any one of claims 4 to 8, wherein the outputting the excitation signal comprises:
outputting the excitation signal when a heating signal is received, the heating signal being used to instruct the electronic atomization device to start heating.

12. A use state detection device applied to an electronic atomization device, the use state detection device comprising:
an excitation signal output module configured to output an excitation signal for exciting a resonance unit to produce an electromagnetic field, the electromagnetic field being used to induct a heat generation unit to generate heat, the heat generation unit being configured to heat an aerosol-generating article;
a detection signal acquisition module configured to acquire the detection signal fed back by a detection unit, the detection unit being configured to detect the energy attenuation characteristic of the electromagnetic field and output the detection signal; and
a state determination module configured to determine the state of the aerosol-generating article according to the detection signal.

13. A computer readable storage medium storing a computer program, the computer program, when executed by a processor, causing the processor to implement steps of the method according to any one of claims 4 to 11.
